# EUROPEAN PATENT SPECIFICATION

(11) **EP 0 527 033 B1**
(45) Date of publication and mention of the grant of the patent: **09.04.1997**
(21) Application number: 92307117.9
(22) Date of filing: 04.08.1992
(51) Int. Cl.: H01L 23/64, H01L 25/07, H01L 23/52, H01L 23/498, H01L 23/495

(54) **Semiconductor module**
Halbleitermodul
Module semi-conducteur

(30) Priority: 06.08.1991 JP 195589/91
(43) Date of publication of application: 10.02.1993
(73) Proprietor: FUJI ELECTRIC CO. LTD., Kawasaki 210 (JP)
(72) Inventor: Kobayashi, Shinichi, c/o Fuji Electric Co., Ltd., Kawasaki (JP); Miyasaka, Tadashi, c/o Fuji Electric Co., Ltd., Kawasaki (JP); Shimizu, Toshihisa, c/o Fuji Electric Co., Ltd., Kawasaki (JP)
(74) Representative: Carmichael, David Andrew Halliday

(56) References cited:
- EP-A- 0 194 133
- EP-A- 0 277 546
- EP-A- 0 340 466
- PATENT ABSTRACTS OF JAPAN vol. 12, no. 328 (E-654) 6 September 1988; & JP-A-63 093 126

## Description

The present invention relates to a semiconductor module accommodating a plurality of semiconductor elements fixed on the insulating plates of one container, and having each element connected to the other, as well as to external terminals.

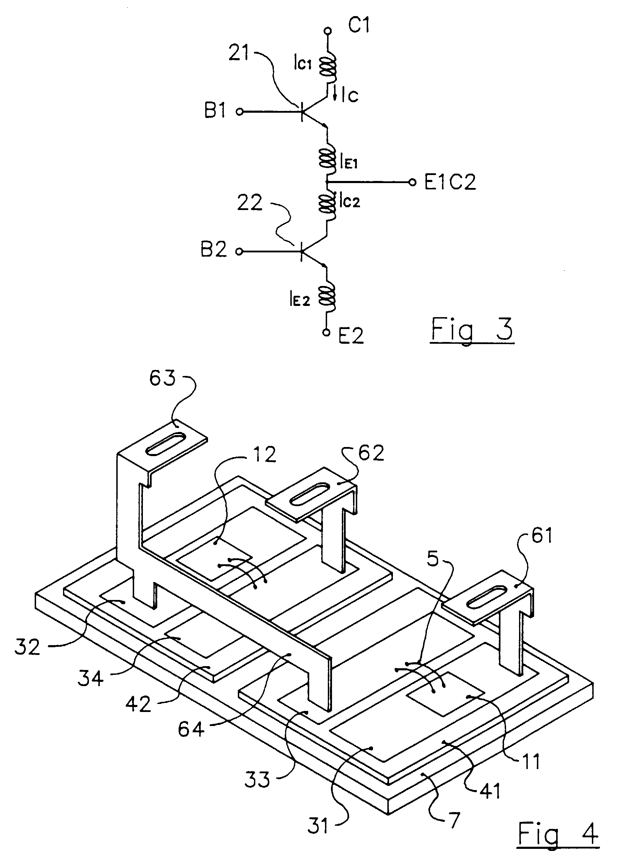

Modules which comprise a plurality of semiconductor elements such as transistor chips connected with each other and contained in a container with external terminals are used widely as modules for constructing circuits. An example of such a module is shown in Figure 3, where the emitter electrode of a first transistor 21 is connected to the collector electrode of a second transistor 22. In addition to the collector terminal conductor C1 of the transistor 21 and the emitter terminal conductor E2 of the second transistor 22, the module has a connecting wire for the terminal E1C2. The wire is drawn out from the common connection of both transistors. As shown in Figure 4, the module has a structure in which the chip 11 corresponding to the transistor 21 and the chip 12 corresponding to the transistor 22 are fixed onto the collector electrode conductors 31, 32 on the insulating plates 41, 42, the emitter electrodes on the chips 11, 12 are connected to the emitter electrode conductors 33, 34 on the insulating plates 41, 42, respectively, by using the connecting wire 5, and the C1 terminal 61 is connected to the collector electrode conductor 31, the E2 terminal conductor 62 to the emitter electrode conductor 34, and the E1 C2 terminal conductor 63 is connected to the emitter electrode conductor 33 and to the collector electrode conductor 32. Furthermore, the insulating plates 41, 42 are fixed to the container bottom plate 7, and the terminal conductors 61, 62, 63 are drawn to above the container.

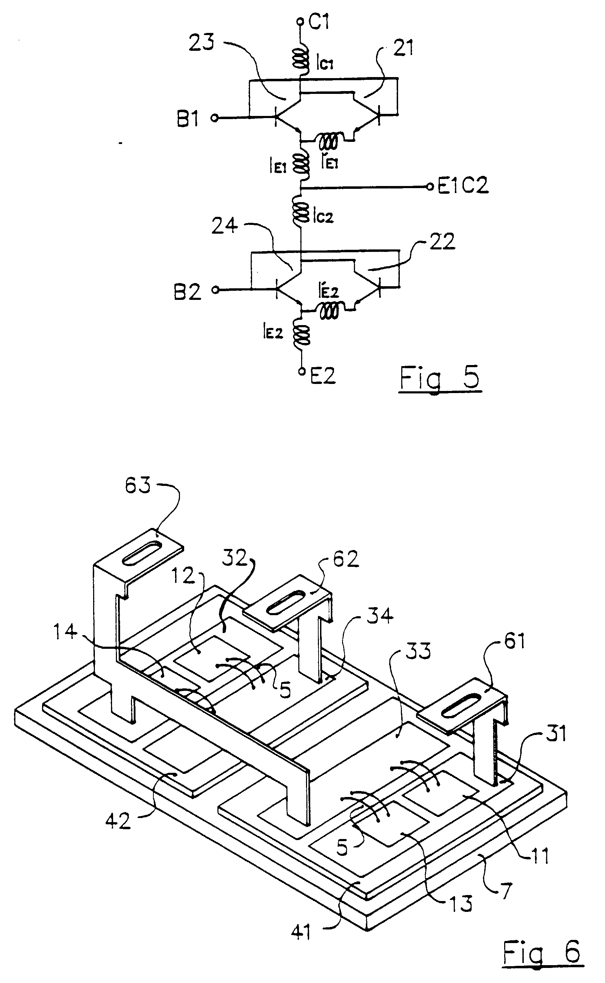

Otherwise, in such a module, which is one as shown in Figures 5 and 6 and has connecting wires for connecting the transistors 23, 24 to the transistors 21, 22 shown in Figure 3 in parallel, the chip 13 of the transistor 23 is fixed to the electrode conductor 31 on the insulation plate 41 in addition to the chip 11 of the transistor 21, while the chip 14 of the transistor 24 is fixed to the electrode conductor 32 on the insulation plate 42 in addition to the chip 12 of the transistor 22. The terminal conductors 61, 62, 63 are drawn out in the similar manner as in Figure 4.

EP-A-340 466 shows a structure where a bond wire between an electrode of a semiconductor element and its corresponding terminal is provided with a shunt connector of larger current capacity than the bond wire extending from the electrode to the terminal. Should the bond wire fuse due to excessive current loading, failure of the element is prevented by the current passing through the shunt connector.

According to the construction shown in Figure 4, there exists as shown in Figure 3 the floating inductance I_{C1} in the terminal conductor 61, the floating inductance I_{E2} in the terminal conductor 62, the floating inductance I_{E1} and the floating inductance I_{C2} in the terminal conductor 63. There is a problem that the floating inductance I_{E1} of the bridge 64 in the terminal conductor 63 for connecting the two transistors 21, 22 and the rate of current variation dl_{c}/dt at turning off the transistors result in generating the surge voltage △ V = l_{E1} • dl_{c}/dt, which is applied to the transistor 21 causing the chip 11 to break down. To solve this problem, it is possible to locate the emitter electrode conductor 33 on the insulation plate 41 closer to the collector electrode conductor 32 on the insulation plate 42 to reduce the length of the bridge 64. However, it is necessary to give a certain length to the terminal conductors to relieve the stress generated between the container bottom plate 7 with the insulation plate installed thereon and the upper part of the container, which serves to reduce the floating inductance.

Furthermore, according to the structure shown in Figure 6, there exists as shown in Figure 5 the floating inductance I_{E1} between the two transistors 21, 23, causing an increase in the surge voltage applied to the chip 11 of the transistor 21 located further from the E1 C2 terminal conductor 63.

The object of the present invention is to provide a semiconductor module with the floating inductance reduced to decrease the surge voltage generated during a change in current, which voltage is due to the floating inductance of conductors connecting elements of a semiconductor module containing a plurality of semiconductor elements in one container.

To achieve the above objective, the present invention provides a semiconductor module comprising two semiconductor elements each having first and second main electrodes, a first main terminal conductor connected to the first main electrode of the first element by a first electrode conductor and a second main terminal conductor connected to the second main electrode of the second element by a second electrode conductor, and one intermediate terminal conductor is connected to both the second main electrode of the first element and to the first main electrode of the second element by a third electrode conductor and a fourth electrode conductor, characterised in that a shunt conductor is connected, in parallel with the intermediate terminal conductor, between the second main electrode of the first element and the first main electrode of the second element, the shunt conductor having a lower floating inductance and a higher resistance than the part of the intermediate terminal conductor between the second main electrode of the first element and the first main electrode of the second element.

In addition, it is effective to construct a semiconductor module characterised in that two or more semiconductor elements are fixed on each first and fourth electrode conductor, whereas connecting conductors with a nearly equivalent floating inductance and resistance are connected to the first electrode conductor of the second element at locations nearly equidistant from each element. It is also effective to construct a semiconductor module characterised in that the connecting conductors are arranged at locations closer to the second electrode conductor of the first element and the first electrode conductor of the second element.

Embodiments of the invention will now be described in detail with reference to the accompanying drawings, in which:
Figure 1 is an equivalent circuit diagram for the semiconductor module according to the first and second embodiments of the present invention;
Figure 2 is an equivalent circuit diagram for the semiconductor module according to the third and fourth embodiments of the present invention;
Figure 3 is an equivalent circuit diagram for one example of a conventional semiconductor module;
Figure 4 is a perspective view of the container interior of a semiconductor module with the equivalent circuit shown in Figure 3;
Figure 5 is an equivalent circuit diagram for another example of a conventional semiconductor device;
Figure 6 is a perspective view of the container interior of a semiconductor module with the equivalent circuit shown in Figure 5;
Figure 7 is a perspective view of the container interior of a semiconductor module according to the first embodiment of the present invention;
Figure 8 is a perspective view of the container interior of a semiconductor module according to the second embodiment of the present invention;
Figure 9 is a perspective view of the container interior of a semiconductor module according to the third embodiment of the present invention; and
Figure 10 is a perspective view of the container interior of a semiconductor module according to the fourth embodiment of the present invention.

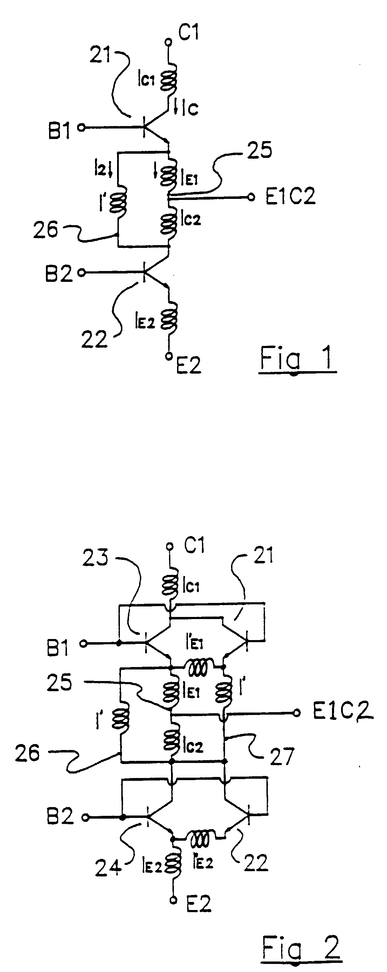

Figure 1 shows an equivalent circuit of the semiconductor module according to the present invention, in which the semiconductor elements are transistors. The same numerals are given to the parts common to those in Figure 3. The equivalent circuit is disposed with the shunt conductor 26 connected in parallel to that part of the terminal conductor 25 which lets the main current flow therein from the emitter of the first transistor 21 to the collector of the second transistor 22 and is connected to the E1 C2 terminal conductor. The shunt conductor 26 has a high direct current resistance as well as a lower floating inductance I' than the floating inductance I_{E1} of the terminal conductor 25. As a result, the stationary current flows through the terminal conductor 25 which has a smaller resistance. However, when the current begins to decrease as the first transistor 21 is turned off, the terminal conductor 25 is brought to have higher alternating current impedance and the current is shunted to the shunt conductor 26, because the floating inductance I_{E1} is higher than the floating inductance I' in the shunt conductor 26. This parallel connection reduces the floating inductance between the emitter of the first transistor 21 and the collector of the second transistor 22, thereby suppressing the surge voltage. Since the time during which the current flows through the shunt conductor is only that time during which the current decreases, a problem such as heat generation due to a voltage drop does not occur even if the direct current resistance is high.

Figure 2 also shows another equivalent circuit of the semiconductor device according to the present invention, having four transistors as the semiconductor elements, with the parts that are same as those in Figure 5 given the same numerals. In this case, another shunt conductor 27 is disposed, and is connected in proximity to the first transistor 21, while the shunt conductor 26 is connected in proximity to the third transistor 23. The shunt conductor 27 has nearly the same floating inductance I' and resistance as the shunt conductor 26, and therefore, a current of nearly the same magnitude is shunted to both of the shunt conductors 26, 27 when the first and third transistors 21, 23 are turned off, and no surge voltage due to the current through the floating inductance I_{E1} is generated.

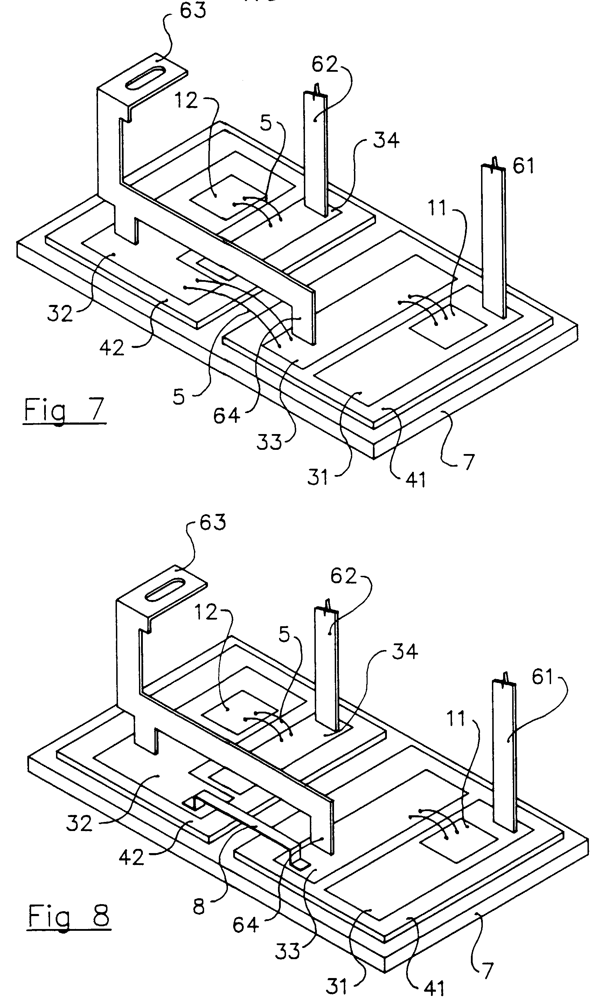

Figure 7 shows a first embodiment of the present invention, with the parts common to those in Figure 4 given the same reference numerals. What differs from Figure 4 is that the electrode conductor 32 is formed so that part of the collector electrode conductor 32 on the insulation plate 42 is located closer to the emitter electrode 33 on the insulation plate 41, and these are connected via an ultrasonic bonding with two thin metallic wires 5 made of the same thin aluminium wire as the leads used to connect the transistor chips 11, 12 to the emitter electrode conductors 33, 32. Selecting the thin metallic wire in a manner that ensures that its length is shorter and its floating inductance is smaller than those of the bridge 64 on the E1C2 terminal conductor 63 results in an equivalent circuit as shown in Figure 1. In this circuit when the first transistor 21 is in the 'on' state, the main current flows along a path from C1 to the transistor 21 and then to I_{E1} and terminal E1 C2. As the main current I_{c} decreases when the transistor 21 is turned off, a surge voltage △V of I_{E1} x dl_{c}/dt is generated as described earlier on the emitter side of the transistor 21 in accordance with the magnitude of dl_{c}/dt and the floating inductance I_{E1}. However, because the current I_{C} is shunted into the current I₁ flowing into I_{E1} and the current I₂ flowing into the floating inductance I' in the thin metallic wires 5, the surge voltage on the emitter side of the transistor 21 is I_{E1}dl₁/dt. The floating inductance I' and I_{C2} between the collector electrode conductor 32 and the terminal 63 is sufficiently lower than I_{E1}, hence I₁ < <I₂, and I_{E1}dl₁/dt < <I_{E1}dl_{c}/dt, thus the surge current applied to the transistor 11 is reduced.

Figure 8 shows a second embodiment of the present invention, with the parts that are the same as those in Figure 4 given the same reference numerals. While in Figure 7 the shunt conductor 5 was formed from the same thin metallic wire used to connect the transistor chips 11, 12 to the electrode conductors 33, 32 located on the insulation plates 41, 42, the shunt conductor 8 used in Figure 8 is a thin and short metal strip. Its effect is the same as in the first embodiment, but the manufacturing process can be more rationalised than in the first embodiment because the metallic terminal conductors 61, 62, 63 and this shunt conductor 8 can be soldered together simultaneously.

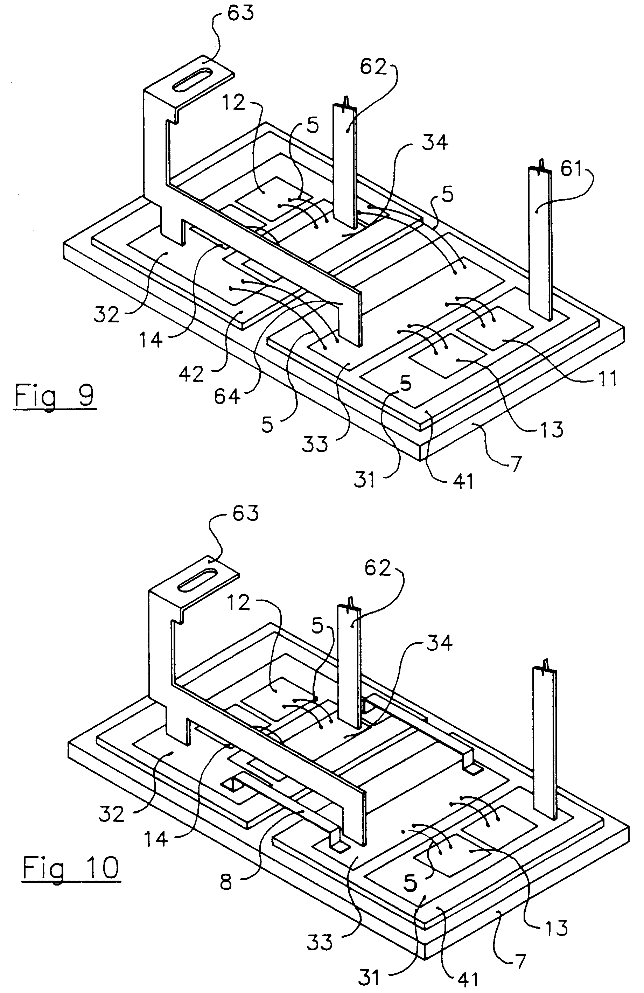

Figures 9 and 10 respectively show a third and fourth embodiment of the present invention, with the parts that are the same as those in Figure 6 given the same numerals. In this case, the collector electrode conductor 32 is so formed that the collector electrode conductor 32 on the insulation plate 42 is located closer to the emitter electrode conductor 33 on the insulation plate 41 at two outer side locations of the chips 12, 14, with two thin metallic wires 5 or the shunt conductor 8 consisting of one metal strip connected across them. If the lengths of the paths from the chips 12, 14 to the emitter electrode conductor 33 through the adjoining thin metal wires 5 or the shunt conductor 8 are made to be nearly the same, an equivalent circuit as shown in Figure 2 is obtained, whereas the floating inductance I' becomes sufficiently smaller than the floating inductance I_{E1} of the bridge 64 of the terminal conductor 63, enabling the surge voltage generated at I_{E1} to be decreased, as well as the surge voltage resulting from the floating inductance I_{E1} existing in the emitter electrode conductor 34 between the chips 12, 14 to be suppressed. The same effect may be achieved if the thin metallic wire 5 or the shunt conductor 8 is arranged in the middle of the chips 12, 14, rather than on both sides. The same effect may also be obtained when the number of chips on one electrode conductor is more than three. This can be done by installing the connecting conductors at locations closer to each chip.

The above embodiments used two insulation plates, but these plates may be combined into one to obtain the same effect. In addition, while the semiconductors were transistors in the above embodiments, this invention can be applied similarly to the case where the semiconductors are IGBT or MOSFET, making it possible to achieve the effect more remarkably because the rate of current change dl_{c}/dt in them at turning off is larger than in transistors.

Utilising the teachings of the present invention, the surge voltage due to high floating inductance of the wiring which connects the intermediate terminal conductor with one of the series connected semiconductor elements contained in the module is suppressed by disposing between these elements one or a plurality of bypassing means with a low inductance and a high resistance. This facilitates the construction of a semiconductor module that provides terminals wired with low internal inductance, and reduces the surge voltage applied to the elements at turning off thus making it possible not only to improve the reliability of the semiconductor module, but also to reduce the limitations in designing the externally drawn-out terminals, thereby increasing freedom in design.

## Claims

1. A semiconductor module comprising two semiconductor elements (11,12) each having first and second main electrodes (E1,C1,E2,C2), a first main terminal conductor (61) connected to the first main electrode (C1) of the first element (11) by a first electrode conductor (31) and a second main terminal conductor (62) connected to the second main electrode (E2) of the second element (12) by a second electrode conductor (34), and one intermediate terminal conductor (E1C2;63) is connected to both the second main electrode (E1) of the first element and to the first main electrode (C2) of the second element by a third electrode conductor (33) and a fourth electrode conductor (32), characterised in that a shunt conductor (5,8) is connected, in parallel with the intermediate terminal conductor (E1C2;63), between the second main electrode (E1) of the first element (11) and the first main electrode (C2) of the second element (12), the shunt conductor (5,8) having a lower floating inductance and a higher resistance than the part (64) of the intermediate terminal conductor between the second main electrode (E1) of the first element (11) and the first main electrode (C2) of the second element (12).

2. A semiconductor module as claimed in Claim 1, characterised in that two or more semiconductor elements (11,12,13,14) are fixed on each first and fourth electrode conductor (31,32).

## Patentansprüche

1. Halbleitermodul, das zwei Halbleiterelemente (11, 12), wobei jedes erste und zweite Hauptelektroden (E1, C1, E2, C2) aufweist, einen ersten Hauptanschlußleiter (E1), der mit der ersten Hauptelektrode (C1) des ersten Elements (11) verbunden ist, und einen zweiten Hauptanschlußleiter (E2) aufweist, der mit der zweiten Hauptelektrode (E2) des zweiten Elements (12) durch erste Elektrodenleiter (31,32) verbunden ist, und ein Zwischenanschlußleiter (E1C2;63) ist sowohl mit der zweiten Hauptelektrode (E1) des ersten Elements als auch mit der ersten Hauptelektrode (C2) des zweiten Elements durch zweite Elektrodenleiter (33,34) verbunden, dadurch gekennzeichnet, daß ein Nebenschlußleiter (5,8) parallel mit dem Zwischenanschlußleiter (E1C2;63), zwischen der zweiten Hauptelektrode (E1) des ersten Elements (11) und der ersten Hauptelektrode (C2) des zweiten Elements (12) geschaltet ist, wobei der Nebenschlußleiter (58) eine niedrigere schwebende Induktivität und einen höheren Widerstand als der Abschnitt (64) des Zwischenanschlußleiters zwischen der zweiten Hauptelektrode (E1) des ersten Elements (11) und der ersten Hauptelektrode (C2) des zweiten Elements (12) aufweist.

2. Halbleitermodul nach Anspruch 1, dadurch gekennzeichnet, daß zwei oder mehrere Halbleiterelemente (11,12,13,14) an jeder ersten Elektrode (31,32) befestigt sind.

## Revendications

1. Module à semiconducteurs comprenant deux éléments semiconducteurs (11, 12) ayant chacun des premières et secondes électrodes principales (E1, C1, E2, C2), un conducteur (61) de première borne principale relié par un conducteur (31) de première électrode à la première électrode principale (C1) du premier élément (11) et un conducteur (62) de seconde borne principale relié par un conducteur (34) de seconde électrode à la seconde électrode principale (E2) du second élément (12), et un conducteur (E1C2 ; 63) de borne intermédiaire est relié à la fois à la seconde électrode principale (E1) du premier élément et à la première électrode principale (C2) du second élément par un conducteur (33) de troisième électrode et un conducteur (32) de quatrième électrode, caractérisé en ce qu'un conducteur (5, 8) en dérivation est monté, en parallèle avec le conducteur (E1C2; 63) de borne intermédiaire, entre la seconde électrode principale (E1) du premier élément (11) et la première électrode principale (C2) du second élément (12), le conducteur (5, 8) en dérivation ayant une inductance flottante inférieure et une résistance supérieure à la partie (64) du conducteur de borne intermédiaire entre la seconde électrode principale (E1) du premier élément (11) et la première électrode principale (C2) du second élément (12).

2. Module à semiconducteurs selon la revendication 1, caractérisé en ce que deux éléments semiconducteurs (11, 12, 13, 14) ou plus sont fixés sur chacun des conducteurs (31, 32) de première et quatrième électrodes.
